# EUROPEAN PATENT APPLICATION

(11) **EP 2 299 475 A1**
(43) Date of publication of application: **23.03.2011**
(21) Application number: 10002884.4
(22) Date of filing: 18.03.2010
(51) Int. Cl.: H01L 21/02

(54) **Improved fabrication and structures of crystalline material**

(30) Priority: 18.09.2009 US 562206
(71) Applicant: Taiwan Semiconductor Manufacturing Co., Ltd., Science-Based Industrial Park Hsin-Chu, 300-77 (TW)
(72) Inventor: Park, Ji-Soo, Andover, MA 01810 (US); Fiorenza, James, G., Wilmington, MA 01887 (US)
(74) Representative: TER MEER - STEINMEISTER & PARTNER GbR

(57) **Abstract**

A surface of the first semiconductor crystalline material has a reduced roughness. A semiconductor device includes a low defect, strained second semiconductor crystalline material over the surface of the first crystalline material. A surface of the strained second semiconductor crystalline material has a reduced roughness. One example includes obtaining a surface with reduced roughness by creating process parameters that reduce impurities at an interfacial boundary between the first and second semiconductor crystalline materials. In one embodiment, the first semiconductor crystalline material can be confined by an opening in an insulator having an aspect ratio sufficient to trap defects using Aspect Ratio Trapping techniques.

## Description

### CROSS-REFERENCE TO RELATED APPLICATIONS

The present application claims priority from United States provisional patent application, serial number US61/098,734, filed September 19, 2008, by Ji-Soo Park and James G. Fiorenza entitled "IMPROVED FABRICATION AND STRUCTURES OF CRYSTALLINE MATERIAL" and incorporated by reference herein and for which benefit of the priority date is hereby claimed.

### BACKGROUND OF THE INVENTION

### 1. Field of the Invention

The present invention relates to fabrication or structures including a semiconductor crystalline material. For example, improved epitaxial growth or structures may occur over a planarized surface including a semiconductor crystalline material.

### 2. Description of the Related Art

This section provides background information and introduces information related to various aspects of the disclosure that are described and/or claimed below. These background statements are not admissions of prior art.

Integration of lattice-mismatched semiconductor materials is one path to high performance devices such as complementary metal-oxide-semiconductor (CMOS) field-effect transistors (FET) due to their high carrier mobility. For example, the heterointegration of lattice-mismatched semiconductor materials with silicon will be useful for a wide variety of device applications.

One heterointegration method involves replacing silicon (Si) channel with high-mobility materials for CMOS devices, for example, high-performance devices beyond the limit of device scaling. However, planarization is typically required for device fabrication because deviations from a flat surface can lead to device fault and/or different device characteristics within an IC or different device characteristics among concurrently manufactured devices. Chemical mechanical polishing (CMP) of the selected lattice-mismatched semiconductor materials is an option to smooth the surface of the material. However, the CMP surface must be smooth and surface impurities must be avoided. Additional cleaning of a polished surface during preparation should not substantially impair its smoothness. Thus, there exists a need to prepare a surface of lattice-mismatched materials in a confined or selectively grown area (e.g., an active region of crystalline materials), which may include planarized materials for subsequent processing.

Further, there is a need to reduce the surface roughness of semiconductor crystalline materials. For example, there is a need to reduce the surface roughness of semiconductor crystalline materials associated with various Aspect Ratio Trapping (ART) techniques in corresponding semiconductor devices.

### SUMMARY OF THE INVENTION

Embodiments according to the present invention provide methods and apparatus to form semiconductor crystalline materials suitable for device fabrication and/or devices made thereby.

In one aspect, one embodiment of the invention can provide planarized heteroepitaxial regions (e.g., wafers) suitable for device fabrication and/or devices including the same.

In another aspect, one embodiment of the invention can provide clean planarized heteroepitaxial regions suitable for device fabrication and/or devices including the same.

In another aspect, one embodiment of the invention can provide reduced or low impurity planarized heteroepitaxial regions suitable for device fabrication and/or devices including the same.

In another aspect, one embodiment of the invention can provide planarized heteroepitaxial regions heated under selected conditions suitable for device fabrication and/or devices including the same.

In another aspect, one embodiment of the invention can provide planarized heteroepitaxial regions having selected characteristics suitable for device fabrication and/or devices including the same.

Therefore, it is an aspect of one embodiment of the invention to provide an epitaxially grown semiconductor crystalline material with a reduced surface roughness.

An alternative aspect of one embodiment of the invention is to provide a semiconductor crystalline material with a reduced surface roughness at a planarized (e.g., different) semiconductor crystalline material.

An alternative aspect of one embodiment of the invention is to provide an epitaxially grown crystalline material with a reduced surface roughness over an interface having reduced impurities to another grown crystalline material.

In yet another aspect, one embodiment of the invention provides a process for the epitaxial growth of a strained, low defect crystalline material at a planarized semiconductor crystalline material.

In yet another aspect, one embodiment of the invention provides a process for preparing a semiconductor crystalline material with reduced surface roughness for subsequent processing and/or semiconductor devices including the surface.

These aspects may be especially applicable to devices incorporating Aspect Ratio Trapping (ART) techniques, including but not limited to a mixed signal application device, a field effect transistor, a quantum tunneling device, a light emitting diode, a laser diode, a resonant tunneling diode and a photovoltaic device. The ART devices may have crystalline material epitaxially grown in openings or confined areas with an aspect ratio (depth/width) > 1, or otherwise suitable for trapping most defects.

Additional aspects and utilities of the invention will be set forth in part in the description which follows and, in part, will be obvious from the description, or may be learned by practice of the invention.

### BRIEF DESCRIPTION OF THE DRAWINGS

These and/or other aspects and utilities of the present general inventive concept will become apparent and more readily appreciated from the following description of the embodiments, taken in conjunction with the accompanying drawings, of which:

Figure 1a is a diagram that illustrates a cross-sectional schematic of strained-Ge on SiGe in trenches using ART.

Figure 1b is a diagram that illustrates a cross-sectional schematic of an alternate configuration (e.g., confined area for crystalline material) of an ART structure.

Figure 2 comprises Figures 2(a) - 2(b). Figures 2(a) - (b) illustrate SEM images of (a) as-grown Si_{0.2}Ge_{0.8}and in trenches and (b) after CMP.

Figure 3 comprises Figures 3(a) - 3(c). Figures 3(a) - 3(c) illustrate (a) SEM and (b) cross-sectional TEM image of Ge on Si_{0.2}Ge_{0.8} in trenches without pre-bake step prior to Ge growth and (c) the magnified TEM image at Ge/Si_{0.2}Ge_{0.8} interface.

Figure 4 comprises Figures 4(a)-4(c). Figures 4(a) - 4(c) illustrate (a) SEM and (b) cross-sectional TEM image of Ge on Si_{0.2}Ge_{0.8} in trenches with the 750 °C pre-bake step prior to Ge growth and (c) the magnified TEM image at Si_{0.2}Ge_{0.8} interface.

Figure 5, comprising Figures 5(a)-5(c). Figures 5(a) - 5(c) illustrate (a) SEM and (b) cross-sectional TEM image of Ge on Si_{0.2}Ge_{0.8} in trenches with the 810 °C pre-bake step prior to Ge growth and (c) the magnified TEM image at Ge/Si_{0.2}Ge_{0.8}.

Figure 6, comprising Figures 6(a)-6(b). Figures 6(a) - 6(b) illustrate SIMS depth profiles of oxygen of blanket Ge/Si_{0.2}Ge_{0.8} (a) without pre-bake and (b) with 810 °C pre-bake step prior to Ge growth.

Figure 7, comprising Figures 7(a)-7(c). Figures 7(a) - 7(c) illustrate (a) SEM and (b) cross-sectional TEM image of thin Ge on Si_{0.2}Ge_{0.8} in trenches with the 870 °C pre-bake step prior to Ge growth and (c) the magnified TEM image at Ge/ Si_{0.2}Ge_{0.8} interface.

Figure 8, comprising Figures 8(a)-8(b). Figures 8(a) - 8(b) illustrate AFM images of thin Ge on Si_{0.2}Ge_{0.8} in trenches with (a) 810 °C and (b) 870 °C pre-bake step prior to Ge growth.

Figure 9 comprises Figures 9(a) and 9(b) where Figure 9(a) illustrates RSM of {224} peaks of thin Ge on Si_{0.2}Ge_{0.8} in trenches with the 810 °C pre-bake and Figure 9(b) illustrates the plot showing peak positions of Si, Si_{0.2}Ge_{0.8}, and Ge of the Ge on Si_{0.2}Ge_{0.8} in trenches with different pre-bake conditions.

### DETAILED DESCRIPTION OF EMBODIMENTS

Reference will now be made in detail to the embodiments of the present general inventive concept, examples of which are illustrated in the accompanying drawings, wherein like reference numerals refer to like elements throughout. The embodiments are described below in order to explain the present general inventive concept by referring to the figures.

The formation of lattice-mismatched materials has many practical applications. For example, heteroepitaxial growth of group IV materials or compounds, and III-V, 111-N and II-VI compounds on a crystalline substrate, such as silicon, has many applications such as photovoltaics, resonant tunneling diodes (RTD's), transistors (e.g., FET (which can be planar or 3D (e.g., finFET), HEMT, etc.), light-emitting diodes and laser diodes. As one example, heteroepitaxy of germanium on silicon is considered a promising path for high performance p-channel metal-oxide-semiconductor (MOS) field-effect transistors (FET) and for integrating optoelectronic devices with silicon complementary MOS (CMOS) technology. Heteroepitaxy growth of other materials (e.g., of group III-V, III-N and II-VI compounds and other group IV materials or compounds) also is beneficial for these and other applications.

Germanium (Ge), a group IV material, is one of the possible candidates for high-mobility channels for CMOS devices because of its higher carrier mobility compared with silicon (Si). In addition, compressive strain in Ge was reported to show further enhancement in carrier mobility likely caused by band splitting and reduction of hole effective mass. Significant improvements in device performance have been demonstrated using compressively-strained Ge channel. However, to date methods to form such structures and/or such structures remain difficult to achieve.

For example, the dislocation density of the epitaxially grown material can be unacceptably high for many applications. For example, the dislocation density of germanium directly grown on silicon can be as high as 10⁸-10⁹ cm⁻² due to the 4.2% lattice mismatch between the two materials-unacceptable for most device applications. Various approaches to reducing the defect density have been pursued, including compositional grading, and post-epi high-temperature annealing. However, these approaches may not be optimal for integration with silicon-based CMOS technology due to requirements for thick epi-layers and/or high thermal budgets, or due to incompatibility with selective growth at a density suitable for CMOS integration.

Aspect Ratio Trapping (ART) is a defect reduction technique that mitigates these problems. As used herein, "ART" or "aspect ratio trapping" refers generally to the technique(s) of causing defects to terminate at non-crystalline, e.g., dielectric, sidewalls, where the sidewalls are sufficiently high relative to the size of the growth area so as to trap most, if not all, of the defects. ART utilizes high aspect ratio openings, such as trenches or holes, to trap dislocations, preventing them from reaching the epitaxial film surface, and greatly reduces the surface dislocation density within the ART opening.

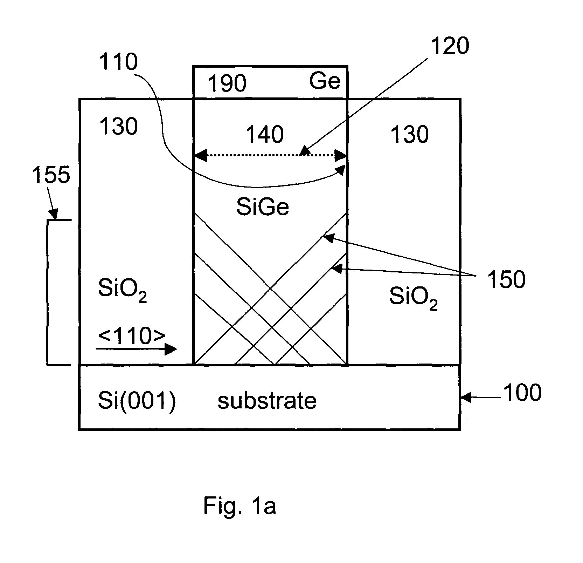

Figure 1a is a diagram that shows a cross section of a lattice-mismatched material 140 of high quality above a defect trapping region 155 using ART. As illustrated here, a crystalline material 140 is epitaxially grown on substrate 100 (here, for example, on the (001) surface of a silicon substrate). By confining the crystalline growth within an opening 120 (e.g., trench, recess or the like) of insulator 130 with a sufficiently high aspect ratio (e.g., 1 or greater, 0.5 or greater), defects 150 (e.g., threading dislocations) formed while epitaxially growing the crystalline material 140 travel to and end at the sidewalls (e.g., insulator sidewalls) 110. Thus, the crystalline material 140 continues to grow without the continued growth of the defects 150, thereby producing crystal with reduced defects above the defect trapping region 155. Defects 150 in the crystalline material 140 can decrease in density with increasing distance from the bottom portion of the opening 120. Accordingly, the bottom portion of the second crystalline semiconductor material 140 comprises crystalline (e.g., lattice) defects, and the upper portion of the crystalline material is substantially exhausted of crystalline defects. Various crystalline defects 150 such as threading dislocations, stacking faults, twin boundaries, or anti-phase boundaries may thus be substantially eliminated from the upper portion of the crystalline material. This technique has been shown to be effective for growing low defectivity materials such as Ge, InP and GaAs selectively on Si in trenches e.g., 200-450 nm wide and of arbitrary length; an area large enough for devices such as a FET, for example. Such trenches can be wider or narrower.

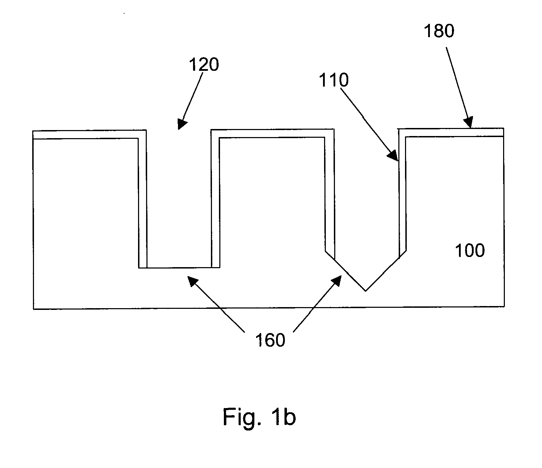

In one example, the width of the opening 120 may be 400 nm or less, 350 nm or less, 200 nm or less, 100 nm or less or 50 nm or less; these sizes have been shown to be effective for ART (of course these sizes do not need to be used with ART). Alternatively, the width of the opening may be 5 µm or less. In another alternative, the width of the opening may be 1 µm or less. The opening may be formed as a trench (with the length of the trench running front to back as shown in Figure 1 a) in which case the width would be considered to be perpendicular to its length and height. The length of the trench may be arbitrary. Alternatively, the length of the trench may be substantially larger than the width of the trench, for example greater than 10 times larger, or greater than 100 times larger. In one example, the length of the trench can be 20 µm.

It is preferred, but not necessary, that the opening 120 is used to trap defects when epitaxially growing the crystalline material 140 using ART (aspect ratio trapping) techniques. (Aspect ratio "AR" is defined for trenches as the ratio of the trench height/trench width.) In such a case, the aspect ratio may be greater than 1, although it possible for the aspect ratio to be lower in ART devices, for example 0.5. In one embodiment, the crystalline material 140 can include two different semiconductor materials or more than one semiconductor material (e.g., GaAs/InP/InGaAs) such as first, second and third materials where the first material can be Ge or GaAs, can be less than 100nm or can have bonding characteristics to a substrate and the third material is polished. Further details of example ART devices and ART techniques in which this invention may be incorporated may be found in U.S. Patent Application Nos. 11/436,198 filed May 17, 2006, 11/493,365 filed July 26, 2006 and 11/852,078 filed September 7, 2007, and U.S. Patent Applications 12/476,460 filed June 2, 2009 entitled "Improved Epitaxial Growth of Crystalline Material" (Attorney Docket no. ASC-3001XX) and 12/503,597 filed July 15, 2009 entitled "Polishing of Small Composite Semiconductor Materials" (Attorney Docket no. ASC-3003XX), all of which are hereby incorporated by reference.

The substrate 100 in the above examples may include a group IV element or compound, such as germanium and/or silicon, e.g., (001) silicon. The crystalline material 140 may include at least one of a group IV element or compound, a III-V or III-N compound, or a II-VI compound. Examples of group IV elements include Ge, Si and examples of group IV compounds include SiGe. Examples of III-V compounds include aluminum phosphide (AIP), gallium phosphide (GaP), indium phosphide (InP), aluminum arsenide (AlAs), gallium arsenide (GaAs), indium arsenide (InAs), aluminum antimonide (AlSb), gallium antimonide (GaSb), indium antimonide (InSb), and their ternary and quaternary compounds. Examples of III-N compounds include aluminum nitride (AIN), gallium nitride (GaN), indium nitride (InN), and their ternary and quaternary compounds. Examples of II-VI compounds include zinc selenide (ZnSe), zinc telluride (ZnTe), cadmium selenide (CdSe), cadmium telluride (CdTe), zinc sulfide (ZnS), and their ternary and quaternary compounds.

The layer of insulator need not be formed as a substantially planar layer. For example, the insulator may be formed of a thin layer that conforms to an undulating surface of the substrate on which it is created. Figure 1b illustrates an example including a substrate that has openings/recesses/trenches 120 etched into the substrate 100. An insulating layer 180 has been formed across the substrate 100 conforming to the surface topography of the etched substrate 100. The insulating layer 180 is configured at the bottom of the openings/trenches to expose portions 160 of the substrate 100 for subsequent lattice-mismatched crystalline material. In this case, sidewalls 110 of the insulating layer 180 can be formed by deposition on or oxidation of the substrate 100 and are not formed by a separate photolithography process. Exemplary configurations of the openings 120 and portions 160 are illustrated however, embodiments of the invention are not intended to be so limited, for example, as other linear, tiered or nonlinear cross-sections may be used for the openings 120 and the portions 160.

An embodiment of the invention is directed to a device including an epitaxially grown first crystalline semiconductor material over a planarized second crystalline semiconductor surface. Preferably the grown first crystalline semiconductor material has a top surface with reduced roughness. Preferably the grown first crystalline semiconductor material is compressively or elastically strained. Preferably the grown first crystalline semiconductor material has low-defectivity that may be similar to the underlying second crystalline semiconductor material. Preferably, the second crystalline semiconductor material is different from the first crystalline material. Preferably, the planarized second crystalline semiconductor surface can be cleaned without impairing a reduced roughness of its surface. Preferably, impurities at an interface between the second crystalline semiconductor material and the first crystalline semiconductor material can be reduced.

An embodiment of the invention is directed to a device including a semiconductor crystalline material over a planarized lattice-mismatched material in an opening in an insulator. Figure 1 a shows one example, illustrating a cross-sectional view of a portion of an exemplary device. As shown in Figure 1a, one example includes the crystalline material 140 (e.g., SiGe alloy; Si_{X}Ge_{1-X}; Si_{0.2}Ge_{0.8}) grown on a substrate 100 in the opening 120 defined in the insulator 130 for a non-Si channel device (e.g., MOSFET). The substrate 100 may be a crystalline material such as silicon, Ge or sapphire. Insulator 130 is preferably a non-crystalline material such as a dielectric material including silicon nitride, SiO₂ or the like. The crystalline material 140 at least at some stage has a surface above the top surface of insulator 130. A planarized surface preferably includes at least a surface of portions of the crystalline material 140 and the insulator 130. An additional semiconductor crystalline material 190 is preferably provided over/at the crystalline material 140.

The following description in connection with Figures 1a-9 explains examples of how surfaces of a low-defect strained crystalline material at or grown over a polished structure (e.g., an ART structure) may be obtained with reduced surface roughness. The following description further describes examples of how surfaces of the lattice-mismatched or crystalline semiconductor material within a confined space (e.g., crystalline material 140 within insulator 130) may be prepared or provided with prescribed surface characteristics. Although this description is in connection with specific materials and process parameters, it will be apparent that the description is exemplary only, and should not be considered to limit the invention to such materials and process parameters.

The following materials and process parameters were used for the Ge grown as discussed in connection with Figures 1a-9. The starting substrates used in this work were crystalline silicon, 200 mm diameter and (001) oriented. A 500-nm-thick thermal oxide was grown on the substrate. The oxide layer was patterned into trenches along [110] direction of the silicon substrate having 200 nm widths. The trenches were formed using conventional photolithography techniques and a reactive ion etching (RIE) step. The patterned substrates were then cleaned in Pirana, SC2, and dilute HF solutions sequentially. Removal of fluorocarbon residues caused by RIE was accomplished using a 25-nm-thick sacrificial oxidation and subsequent dilute HF cleaning (e.g., HF oxide etch). The final trench height was 490 nm after this cleaning procedure. SiGe layers over 500nm were grown by chemical vapor deposition (CVD) on the exposed Si substrate (e.g., in the trenches) in an industrial ASM Epsilon E2000 system. This CVD system is a horizontal, cold-wall, single wafer, load-locked reactor with a lamp-heated graphite susceptor in a quartz tube.

Si_{0.2}Ge_{0.8} layers were grown in the trenches at 600 °C and 80 Torr for 1200 sec using ASM Epsilon E2000 commercial grade epitaxy reactor. 25% germane (GeH₄) diluted in H₂ and 100% dichlorosilane (SiH₂Cl₂) was used as a precursor of germanium and silicon, respectively and hydrogen as a diluent gas. Chemical-mechanical-polishing (CMP) of Si_{0.2}Ge_{0.8} was performed to make the SiGe layers coplanar with oxide sidewall using a Strasbaugh 6EC. A Nalco 2360 slurry (70nm colloidal silica) was used. Nalco 2360 slurry is a commercially available colloidal silica polishing slurry having submicron silica particles in an aqueous solution. Either NaOCl, NH4OH, or H2O2 solution was added to the diluted slurry to enhance the SiGe removal rate relative to the oxide sidewall. Thus, each slurry mix consisted of part Nalco 2360, part chemical additive, and the remainder was deionized water (DI) water, adding up to 100% of the slurry mix. An exemplary CMP process of the Strasbaugh 6EC included ramp-up, a polish, ramp-down and rinse.

An exemplary post-CMP clean, using the Verteq Goldfinger single-wafer megasonic post-CMP tool, included a contamination spin-off, process time, rinse time, and spin dry time. In one example, megasonic power of 125W and DI water at a rate of 1.7-3L/min may be used. After the megasonic post-CMP clean process, the substrates were cleaned in a diluted HF solution. Then, a Ge layer (e.g., 42-nm-thick) was grown on coplanar Si_{0.2}Ge_{0.8} at 350 °C and at the same pressure using the same reactor as the Si_{0.2}Ge_{0.8} growth. Just prior to the Ge growth step in the growth chamber, the wafers were baked at 750, 810, or 870 °C for 1 min in H₂ at the same growth pressure. For comparison, Ge was grown on some wafers without the pre-bake step. Strain of Ge (190) on Si_{0.2}Ge_{0.8} (140) was determined from high-resolution reciprocal space map (RSM) of asymmetric {224} peaks using a Panalytical X'Pert diffractometer. Scanning electron microscopy (SEM) and transmission electron microscopy (TEM) were used for the characterization. Cross-sectional scanning electron microscope (SEM) analysis samples were observed using a Zeiss Supra 40 field-emission SEM. Cross-sectional TEM samples were prepared by mechanical polishing and Ar ion milling and the TEM images were taken on a JEOL JEM 2100 microscope operating at 200 kV.

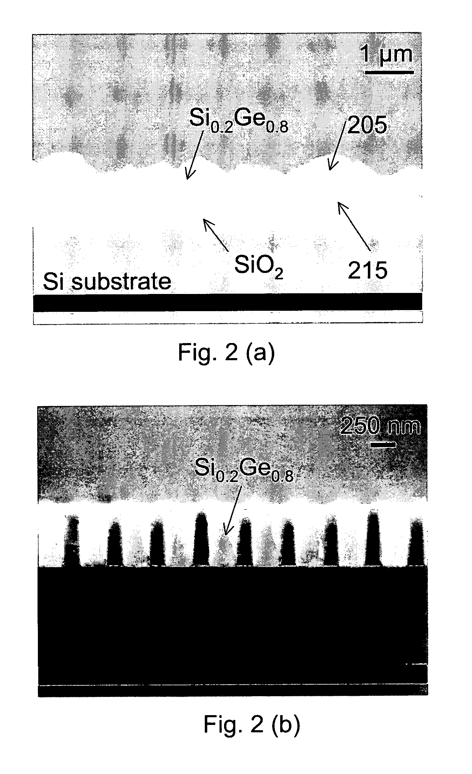

Figures 2(a) and 2(b) show Si_{0.2}Ge_{0.8} in oxide trenches before and after the Si_{0.2}Ge_{0.8} CMP, respectively. The surface of the grown Si_{0.2}Ge_{0.8} is above a top surface of the oxide trenches. The surface of the Si_{0.2}Ge_{0.8} grown over the oxide trenches was very rough because the coalescence of Si_{0.2}Ge_{0.8} was not completely uniform as shown in Fig. 2(a). For example, coalescence of the Si_{0.2}Ge_{0.8} is indicated by arrow 205, however an un-coalesced portion of the Si_{0.2}Ge_{0.8} is indicated by arrow 215. A smooth Si_{0.2}Ge_{0.8} coplanar with the oxide trenches was obtained after CMP as shown in Fig. 2(b), which is suitable for strained-Ge growth and device applications.

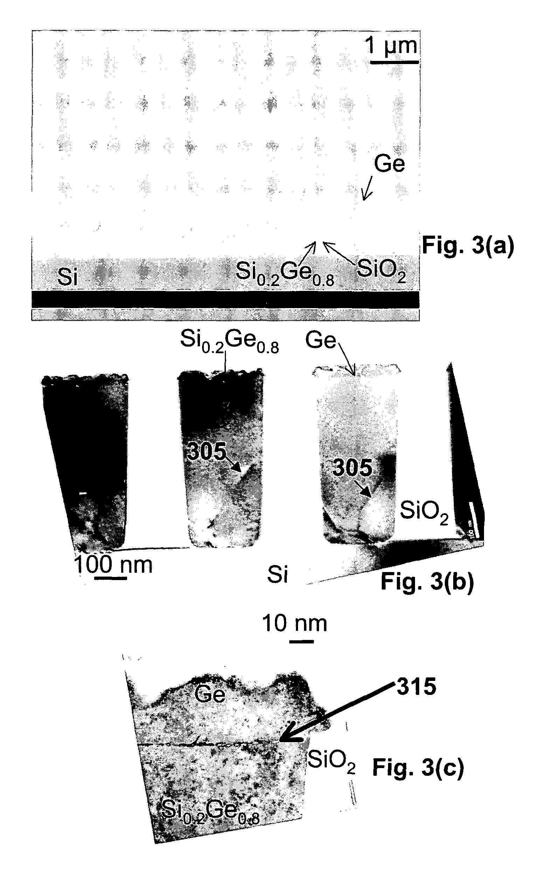

Figure 3(a) is a diagram that illustrates an SEM image of thin Ge on coplanar Si_{0.2}Ge_{0.8} in oxide trenches without the pre-bake step prior to the Ge growth. As shown in Figure 3(a), the Ge growth was selective without the formation of Ge islands on the oxide. To evaluate the Ge crystalline quality and the interface of Ge/Si_{0.2}Ge_{0.8}, TEM experiments were performed. Figure 3(b) is a diagram that illustrates cross-sectional TEM image of the Ge on Si_{0.2}Ge_{0.8} in trenches from Figure 3(a). As shown in Fig. 3(b), threading dislocations (TDs) from the Si_{0.2}Ge_{0.8}/Si interface were trapped by ART techniques as indicated by arrows 305 and the top part of the Si_{0.2}Ge_{0.8} in the trenches has substantially reduced defects or is free of TDs. The interesting thing is that the thin Ge on top of the Si_{0.2}Ge_{0.8} is not smooth. Figure 3(c) is a diagram that illustrates a magnified portion of the cross-sectional TEM image of Figure 3(b). The magnified image shown in Fig. 3(c) exhibits a clear interface between Ge and Si_{0.2}Ge_{0.8} as indicated by an arrow 315. Even after the polishing and cleaning procedures, poor Ge crystalline quality resulted including a rough surface as exemplarily illustrated in Figures 3(a)-3(c) grew on the Si_{0.2}Ge_{0.8}

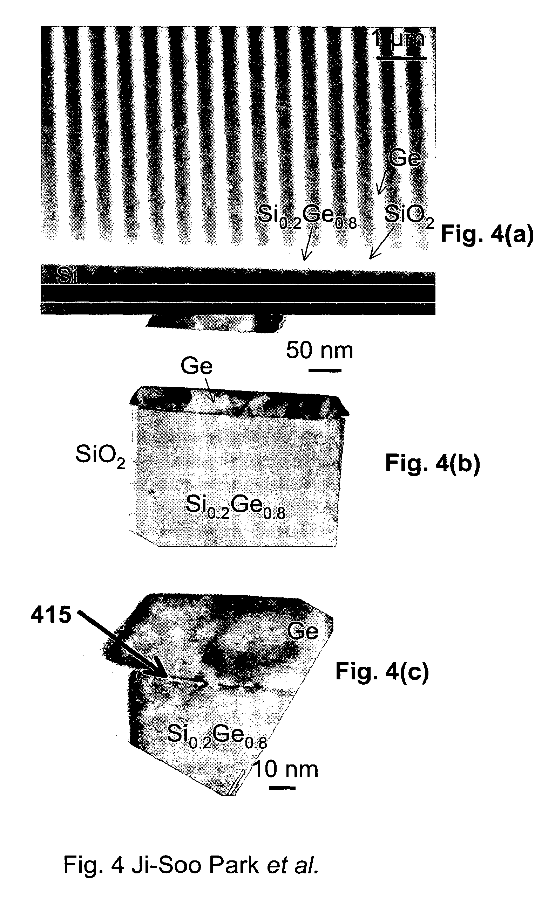

To determine a pre-bake temperature and a corresponding effect on the quality of thin Ge on Si_{0.2}Ge_{0.8}, a pre-bake was performed at 750 °C for one minute before the Ge growth and the results are shown in Figs. 4(a)-4(c). Figure 4(a) is a diagram that illustrates an SEM image of Ge on coplanar Si_{0.2}Ge_{0.8} in oxide trenches with the 750 °C pre-bake, Figure 4(b) is a cross-sectional TEM image of the Ge on Si_{0.2}Ge_{0.8} of Figure 4(a) and Figure 4(c) illustrates a magnified portion of Figure 4(b). In Figure 4(a), the SEM image shows that the sample surface is clean with a good growth selectivity of Ge. In Figure 4(b), the cross-sectional TEM image shows the Ge layer is much smoother than the Ge layer without the pre-bake step shown in Figure 3(c). However, compared to the defect-free underlying Si_{0.2}Ge_{0.8}, the Ge layer shown in Figure 4(c) is more defective and the defects are mainly originated from Ge/Si_{0.2}Ge_{0.8} interface. The magnified image of Fig. 4(c) shows a clear interface and impurities between Ge and Si_{0.2}Ge_{0.8} as indicated by arrow 405. Thus, the 750 °C pre-bake shows some improvement in the quality of thin Ge on Si_{0.2}Ge_{0.8} compared to the Ge on Si_{0.2}Ge_{0.8} shown in Figure 3(a)-3(c). However, removal of impurities such as the moisture and oxygen at the interface as shown in Figure 4(c) may be insufficient so that defects were generated from the interfacial impurities.

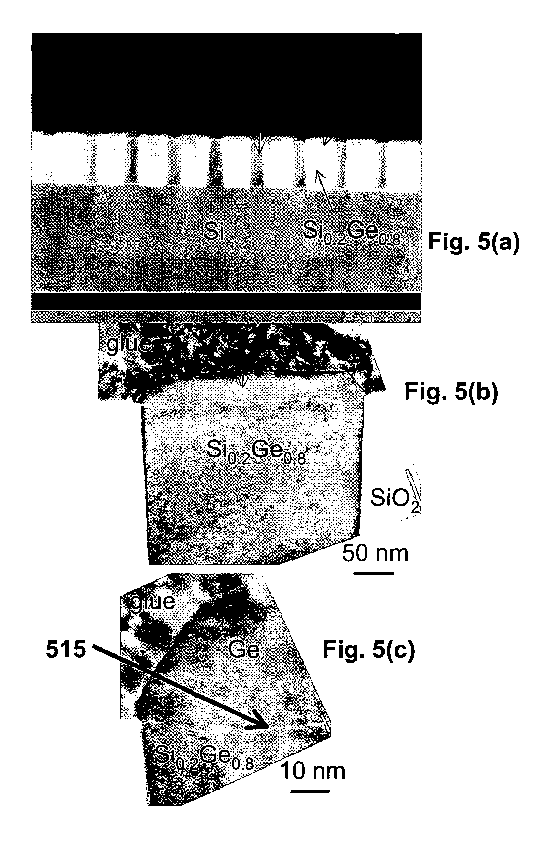

To determine removal of interfacial impurities and crystalline quality of Ge, pre-bake was performed at 810 °C prior to Ge growth and the results are shown in Figs. 5(a)-5(c). Figure 5(a) is a diagram that illustrates an SEM image of Ge on coplanar Si_{0.2}Ge_{0.8} in oxide trenches with the 810 °C pre-bake, Figure 5(b) is a cross-sectional TEM image of the Ge on Si_{0.2}Ge_{0.8} of Figure 5(a) and Figure 5(c) illustrates a magnified portion of Figure 5(b). As shown in Fig. 5(a), the Ge sample surface shows good growth selectivity from the SEM image. As shown in Figure 5(b), the Ge layer does not show noticeable defects and is similar to the underlying defect-free Si_{0.2}Ge_{0.8} in terms of defectivity. The interfacial impurities are slightly shown in Fig. 5(c) as indicated by an arrow 515. However, the interfacial impurities of Figure 5(c) are much less than ones without pre-bake or the pre-bake at 750 °C and did not cause the generation of defects compared to the ones without pre-bake or the pre-bake at 750 °C. Thus, a pre-bake at higher temperature (e.g., 810 °C) can lead to better removal of interfacial impurities at Ge/Si_{0.2}Ge_{0.8} interface, which should make the crystalline quality of Ge even better.

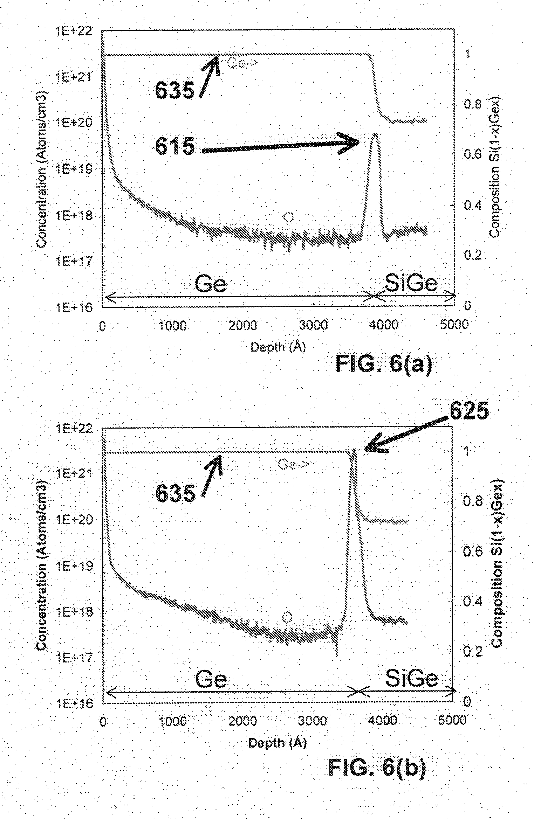

To evaluate the removal (e.g., decrease) of interfacial impurities by the pre-bake, the concentration of oxygen 605 at the Ge/Si_{0.2}Ge_{0.8} was measured using secondary ion mass spectroscopy (SIMS). Figures 6(a) and 6(b) are diagrams that illustrate SIMS depth profiles of 380-nm-thick Ge layer grown on blanket Si_{0.2}Ge_{0.8} after 810 °C pre-bake and without the pre-bake, respectively. As shown in Figures 6(a)-6(b), peak oxygen concentration 615 at the Ge/Si_{0.2}Ge_{0.8} interface is about 4 x 10¹⁹ atoms/cm³ for the 810 °C pre-baked sample prior to Ge growth, but peak oxygen concentration 625 at the Ge/Si_{0.2}Ge_{0.8} interface is 2 x 10²¹ atoms/cm³ without the pre-bake. This result indicates the oxygen concentration at the interface was reduced by almost two orders of magnitude after the 810 °C pre-bake. Also, illustrated in Figures 6(a) and 6(b) is the composition amount of Ge 635 plotted by depth through the 380nm Ge layer on the blanket Si_{0.2}Ge_{0.8} layer.

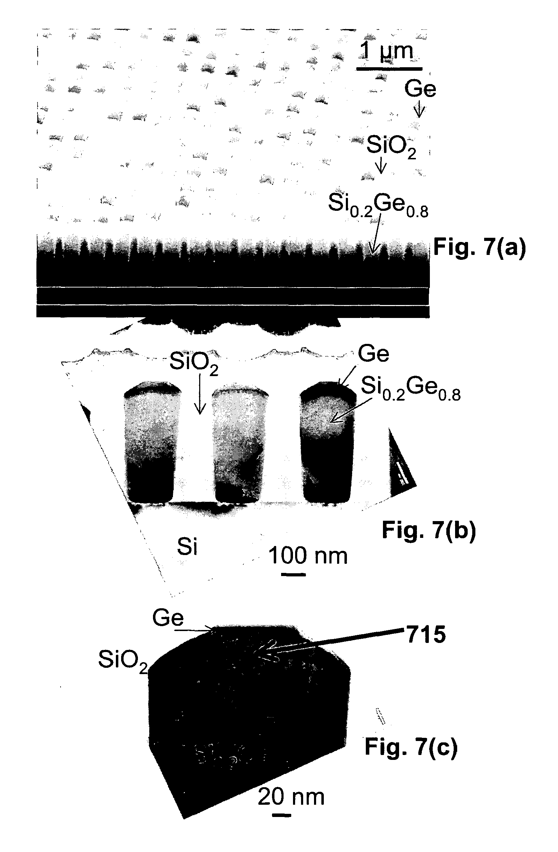

To determine removal of interfacial impurities and crystalline quality of Ge, pre-bake was performed at 870 °C prior to Ge growth and the results are shown in Figs. 7(a)-7(c). Pre-bake at 870 °C may determine an upper limit of the pre-bake temperature. Figure 7(a) is a diagram that illustrates an SEM image of Ge on coplanar Si_{0.2}Ge_{0.8} in oxide trenches with the 870 °C pre-bake. Figure 7(b) is a cross-sectional TEM image of the Ge on Si_{0.2}Ge_{0.8} of Figure 7(a) and Figure 7(c) illustrates a magnified portion of Figure 7(b). Figure 7(a) illustrates that Ge/Si_{0.2}Ge_{0.8} structure in trenches shows an undulation along the trench after the 870 °C pre-bake and the Ge growth. Figures 7(b) and 7(c) show that Ge/Si_{0.2}Ge_{0.8} interface 715 is curved or round and substantially no interfacial impurities were found at the Ge/Si_{0.2}Ge_{0.8} interface. The results shown in Figures 7(a)-7(c) indicate that the 870 °C pre-bake removes interfacial impurities very well compared to the pre-bake at lower temperature. As shown in Figure 7(a) however, the undulated surface of Ge/Si_{0.2}Ge_{0.8} is not suitable for device application. Thus, a surface of the Ge/Si_{0.2}Ge_{0.8} may not suitable for device application if the bake temperature is too high.

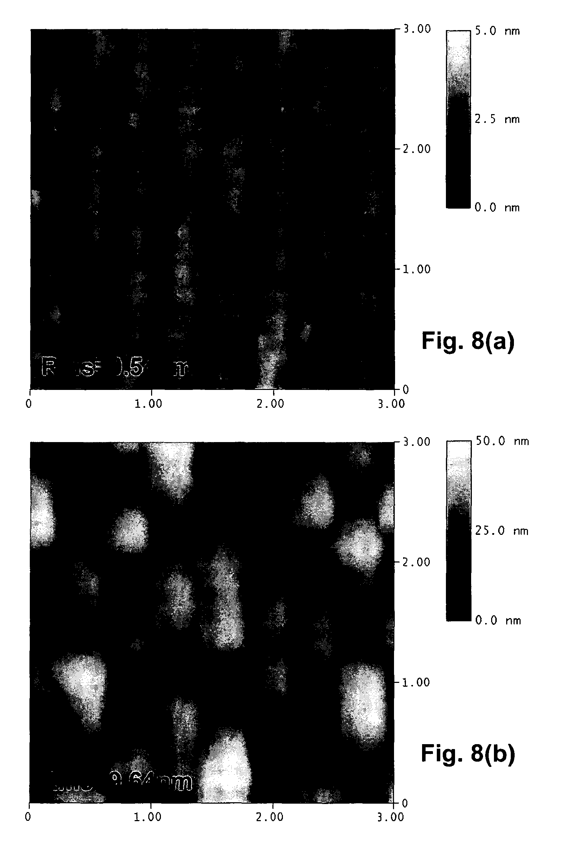

The sample roughness was characterized by tapping-mode atomic force microscopy (AFM) with a Veeco Dimension 3100. Figures 8(a) and 8(b) are diagrams that illustrate atomic force microscope (AFM) images of Ge/Si_{0.2}Ge_{0.8} in trenches with 810°C and 870°C pre-bake, respectively. The 810°C pre-baked sample resulted in a 0.54 nm root-mean-square (RMS) roughness, which can be calculated from the AFM image, but RMS roughness of the 870°C pre-baked sample is 9.64 nm, which is almost 20 times higher due to the undulation along the trenches.

As described above, the Ge layer of crystalline material at least at some stage in during its growth has a surface. In one embodiment, the surface the Ge layer (190) preferably has a surface roughness Rms of less than 7 nm, less than 5 nm, less than 3nm, or less than 1 nm or less than 0.3 nm.

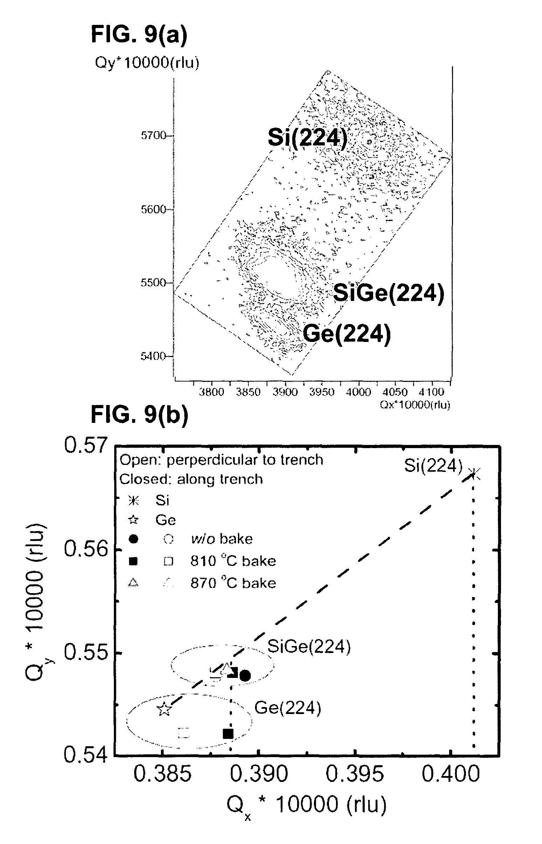

From such exemplary process conditions, strained-Ge/Si_{0.2}Ge_{0.8} structure in trenches was successfully fabricated. Strains in exemplary embodiments of Ge and SiGe can be evaluated using high-resolution RSM of {224} peaks. Figure 9(a) shows {224} RSM of 42-nm-thick Ge on Si_{0.2}Ge_{0.8} in trenches baked at 810 °C prior to Ge growth. {224} peaks of thin Ge and Si_{0.2}Ge_{0.8} in trenches and Si substrate are shown in Figure 9(a). X-ray diffraction measurement was performed along and perpendicular to the trenches to evaluate strain of Ge and Si_{0.2}Ge_{0.8} in both directions. The {224} peak positions of the samples baked at different conditions were plotted in RSM for comparison as shown in Fig. 9(b). As shown in Fig. 9(b), theoretical {224} peak positions of Si and Ge were marked. If SiGe is completely relaxed, its peak will be located on the dashed line between Si and Ge peaks in Fig. 9(b), but it will be on the dot line along surface normal of the layer if they are fully strained. Thus, the peaks of partially relaxed epi-layers will locate between the two lines. From Fig. 8(b), it was found that both Si_{0.2}Ge_{0.8} and Ge are more strained along the trench direction, but more relaxed perpendicular to the trench direction. In addition, Si_{0.2}Ge_{0.8} is almost fully relaxed perpendicular to the trenches even without the bake but the peak position of Si_{0.2}Ge_{0.8} along the trench direction gets closer to the dash line at higher bake temperature indicating it is more relaxed by higher temperature bake. From the lattice constant calculated from the position of Ge (224) peaks, in one embodiment, the 42-nm-thick Ge has 1% and 0.45% elastic strain along and perpendicular to the trench direction, respectively.

As described above, the Ge layer of crystalline material is formed over or at the underlying lattice-mismatched semiconductor crystalline SiGe alloy. Si has smaller lattice constant about 4% smaller than Ge. The lattice-mismatch in this example will vary approximately linearly based the percentages of Si and Ge in the SiGe. A thickness of the Ge layer can vary, but preferably remains sufficiently thin such that the strain is maintained. In one embodiment, the Ge layer (190) is preferably at least 20nm thick, at least 40nm thick, at least 100nm thick or at least 200nm thick.

In one embodiment, the crystalline material 190 has elastic strain at least along a first direction, along a second direction perpendicular to the first direction or along both the first and second directions. Preferably the strain is at least 0.5%, at least 1%, at least 2% or at least 4% compressive strain along the first direction or at least 0.5%, at least 1%, at least 2%, at least 4%compressive strain along the second direction.

While these examples are directed to the CVD growth of germanium on SiGe, other materials may be used. For example, when epitaxially growing by CVD compounds of Group III (Al, Ga, In) and Group V (P, As) such as GaAs, AlGaAs, InGaAs, InAlAs, InGaAlAs, InP, GaP, InGaP, InAlGaP etc., a growth temperature of 500-800 °C is normally used to obtain sufficient growth rates on a blanket substrate. According to a further example, these materials may be grown by CVD at a temperature less than 500 °C or 400-500 °C when grown over a planarized first crystalline material. However, the temperature for the pre-bake or preparation process (e.g., cleaning at higher temperature in H₂ gas) before the growth step is preferably independent of the growth temperature for semiconductor crystalline material to be used.

As another example, compounds of Group III (Al, Ga, In) and Group V (Sb) such as GaSb, AlSb and InSb can be epitaxially grown by CVD on a blanket substrate with a growth temperature in the range of 400-700 °C. According to a further example, these materials may be grown by CVD at a temperature less than 400 °C or 300-400 °C when grown over a planarized first crystalline material. However, the temperature for the pre-bake or preparation process (e.g., cleaning at higher temperature in H₂ gas) before the growth step is preferably independent of the growth temperature for semiconductor crystalline material to be used.

As another example, Group III-N compounds can be epitaxially grown by CVD on a blanket substrate with a growth temperature in the range of 500 - 1100 °C. According to a further example, these materials may be grown by CVD at a temperature less than 500 °C or 400-500 °C when grown over a planarized first crystalline material. However, the temperature for the pre-bake or preparation process (e.g., cleaning at higher temperature in H₂ gas) before the growth step is preferably independent of the growth temperature for semiconductor crystalline material to be used.

As another example, Group II-VI compounds can be epitaxially grown by CVD on a blanket substrate with a growth temperature in the range of 250 - 600 °C. According to a further example, these materials may be grown by CVD at a temperature less than 250 °C or 200-250 °C when grown over a planarized first crystalline material. However, the temperature for the pre-bake or preparation process (e.g., cleaning at higher temperature in H₂ gas) before the growth step is preferably independent of the growth temperature for semiconductor crystalline material to be used.

As another example, Group IV elements and compounds can be epitaxially grown by CVD on a blanket substrate with a growth temperature in the range of 400-1000 °C. According to a further example, these materials may be grown by CVD at a temperature less than 400 °C or 300-400 °C when grown over a planarized ART crystalline material. However, the temperature for the pre-bake or preparation process (e.g., cleaning at higher temperature in H₂ gas) before the growth step is preferably independent of the growth temperature for semiconductor crystalline material to be used.

Thus, for the Group IV, III-V, III-N and II-VI materials in accordance with the above, it is preferred, but not necessary that an elastically strained, low defect layer having reduced surface roughness be provided according to embodiments as variously described above.

According to embodiments of the application, low-defectivity, compressively-strained Ge on polished Si_{0.2}Ge_{0.8} fabricated in oxide-trenches using ART techniques was achieved. In one exemplary embodiment however, an increasingly higher pre-bake temperature may benefit interface characteristics but exceed a thermal tolerance of a device or of the confined crystalline material resulting in unacceptably high surface roughness (rms). One potential cause of the high surface roughness may be lattice-mismatch strain in the confined crystalline material that cannot be released through other mechanisms, which can result in a limited thermal budget for a cleaning or pre-bake process.

As described above, some embodiments according to the application used CMP and a preparation or pre-bake process prior to crystalline growth to improve a surface characteristic or to obtain high quality substantially defect-free and smooth semiconductor crystalline material, however embodiments are not intended to be so limited as various gases and/or intervals may be used. In one embodiment, a pre-bake or cleaning process prior to the growth of the crystalline material 190 lasted for 1 minute. In a further example, the pre-bake process can be at least 10 seconds long, at least 30 seconds long, at least 2 minutes long, at least 5 minutes long or at least 10 minutes long. In a further example, a pre-bake temperature range can be a smaller range within or slightly above a blanket growth temperature range. In one example, gases including hydrogen can be used. For example, hydrogen and inert gas combinations may be used. In one example, hydrogen combined with argon or nitrogen gas can be used. According to embodiments, a pre-bake process can reduce levels of impurities at a planarized surface.

According to embodiments of the application, low-defectivity, compressively-strained Ge on polished Si_{0.2}Ge_{0.8} fabricated in oxide-trenches using ART techniques was achieved. In one example, a pre-bake process used a corresponding temperature range around 760°C to 860°C. In a further example, a pre-bake process can use a temperature range between 780°C to 840°C, a range between 800°C to 820°C, or a temperature around 810°C, however, such temperature ranges are not intended to be so limited as a temperature range will vary with materials and/or conditions actually used. For example, should silicon content be reduced (e.g., Si_{0.1}Ge_{0.9}), a corresponding temperature range may increase.

Exemplary embodiments of low defect, strained semiconductor crystalline material having a reduced surface roughness, semiconductor devices and methods for fabricating and using the same described above disclosed undoped semiconductor materials. However, the present general inventive concept can be applied to n-doped semiconductor materials or p-doped semiconductor materials at known concentration for devices such as those described above with similar results.

In one embodiment, crystalline material 140 may have less than about 1x10⁶ line defects/cm² (e.g., above the defect trapping region 155). Alternatively, crystalline material 140 may have a line defect density of about 1x10⁷ defects/cm² to 1x10⁸ defects/cm² or less. Alternatively, crystalline material 140 may be substantially free of line defects and/or plane defects. According to one embodiment, crystalline material 190 can have a defectivity characteristic matching the underlying crystalline material 140. Dopants are typically added to a semiconductor material to increase its charge carriers (electrons or holes); as is understood in the art, and for the purpose of this application, defects are not considered to include dopants.

As described above, according to embodiments of the application, low-defectivity, compressively-strained Ge on Si_{0.2}Ge_{0.8} was fabricated in oxide-trenches using ART techniques. Pre-bake step in H₂ prior to thin Ge growth on coplanar Si_{0.2}Ge_{0.8} with oxide trenches achieved substantially defect-free and smooth Ge. When a cleaning or bake temperature was too low below 750 °C, removal of interfacial impurities at Ge/Si_{0.2}Ge_{0.8} was insufficient resulting in defective Ge. Oxygen concentration was reduced from 2 x 10²¹ cm³ to 4 x 10¹⁹ cm³ by the 810 °C pre-bake. When a cleaning or bake temperature is too high over 870 °C, SiGe surface was undulated along the trenches and its roughness was increased from 0.54 to 9.64 nm from 5 µm x 5 µm scans using atomic force microscopy. Using the optimum tested pre-bake at 810 °C, 42-nm-thick compressively-strained Ge was grown having 1% and 0.45% elastic strain along and perpendicular to the trench direction, respectively. Thus, embodiments according to the invention have excellent compatibility with silicon CMOS because of low defects levels, small layer thickness and a low thermal budget.

A silicon CMOS device may be processed to include embodiments of the invention; therefore, embodiment of devices such as LEDs or photovoltaic devices according to the invention integrated with CMOS process may be fabricated. For example, a silicon CMOS process can fabricate semiconductor devices (e.g., transistors) or elements (e.g., an electrode, contact hole, contacts) before or after embodiments according to this application for integration. Further, structures and/or methods according to disclosed embodiments can be used for integration of non-Si channel or active regions for next generation CMOS and for a wide variety of other applications.

As noted above, this invention has a wide variety of applications. While not limited to ART technology, this invention has many applications within ART technology. For example, use of this invention may be used to create strained Ge over a SiGe alloy grown in an opening within an insulator. One or both of the Ge and SiGe layers may be grown in accordance with the invention and/or may have a surface of reduced roughness. A wide variety of devices may incorporate the invention. While not limiting to these devices, the invention may be particularly applicable to mixed signal applications, field effect transistors, quantum tunneling devices, light emitting diodes, laser diodes, resonant tunneling diodes and photovoltaic devices, especially those using ART technology. Application Serial No. 11/857047 filed 9/18/2007 entitled "Aspect Ratio Trapping for Mixed Signal Applications"; Application Serial No. 11/861931 filed 9/26/2007 entitled "Tri-Gate Field-Effect Transistors formed by Aspect Ratio Trapping"; Application Serial No. 11/862850 filed 9/27/2007 entitled "Quantum Tunneling Devices and Circuits with Lattice-mismatched Semiconductor Structures"; Application Serial No. 11/875381 filed 10/19/2007 entitled "Light-Emitter - Based Devices with Lattice-mismatched Semiconductor Structures"; and Application Serial No. 12/100131 filed 4/9/2007 entitled "Photovoltaics on Silicon" are all hereby incorporated by reference as providing examples to which aspects of this invention may be particularly suited.

Any reference in this specification to "one embodiment," "an embodiment," "example embodiment," etc., means that a particular feature, structure, or characteristic described in connection with the embodiment can be included or combined in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to affect such feature, structure, or characteristic in connection with other ones of the embodiments. Furthermore, for ease of understanding, certain method procedures may have been delineated as separate procedures; however, these separately delineated procedures should not be construed as necessarily order dependent in their performance. That is, some procedures may be able to be performed in an alternative ordering, simultaneously, etc. In addition, exemplary diagrams illustrate various methods in accordance with embodiments of the present disclosure. Such exemplary method embodiments are described herein using and can be applied to corresponding apparatus embodiments, however, the method embodiments are not intended to be limited thereby.

Although few embodiments of the present invention have been illustrated and described, it would be appreciated by those skilled in the art that changes may be made in these embodiments without departing from the principles and spirit of the invention. The foregoing embodiments are therefore to be considered in all respects illustrative rather than limiting on the invention described herein. Scope of the invention is thus indicated by the appended claims rather than by the foregoing description, and all changes which come within the meaning and range of equivalency of the claims are intended to be embraced therein. As used in this disclosure, the term "preferably" is non-exclusive and means "preferably, but not limited to." Terms in the claims should be given their broadest interpretation consistent with the general inventive concept as set forth in this description. For example, the terms "coupled" and "connect" (and derivations thereof) are used to connote both direct and indirect connections/couplings. As another example, "having" and "including", derivatives thereof and similar transitional terms or phrases are used synonymously with "comprising" (i.e., all are considered "open ended" terms) - only the phrases "consisting of" and "consisting essentially of" should be considered as "close ended". Claims are not intended to be interpreted under 112 sixth paragraph unless the phrase "means for" and an associated function appear in a claim and the claim fails to recite sufficient structure to perform such function.
Illustrative embodiments of the invention are as follows:
1. A semiconductor device, comprising:
   a composite structure comprising a first semiconductor crystalline material interspersed with a high aspect ratio to a second material, the composite structure to have a planar surface; and
   a strained second semiconductor crystalline material over the first semiconductor crystalline material at the planar surface, wherein the surface of the first semiconductor crystalline material has a surface roughness RMS of 5nm or less, and wherein an interface between the first and second semiconductor crystalline materials has reduced impurity concentrations.
2. The device of item 1, wherein the surface of the second semiconductor crystalline material has a surface roughness RMS of about 4nm or less, about 3nm or less, about 1 nm or less, about 0.5nm or less, or no greater than 0.3nm.
3. The device of item 1, wherein the interface has reduced oxygen impurity concentrations.
4. The device of item 1, wherein the strain is along a longitudinal direction of the opening, perpendicular to the longitudinal direction or both along and perpendicular to the longitudinal.
5. The device of item 1, wherein the composite structure comprises: a semiconductor crystalline substrate;
   an insulator having an opening to the substrate;
   the first semiconductor crystalline material within the opening in the insulator, the first semiconductor crystalline material being lattice-mismatched with the substrate.
6. The device of item 5, wherein the substrate is configured with depressions in the substrate, and wherein the insulator overlies sides of the depression to form said opening.
7. The device of item I further comprising a CMOS device integrated with the substrate.
8. The device of item 1, wherein the crystalline material is a group III-V compound.
9. The device of item 1, wherein the interface between the first and second semiconductor crystalline materials is heat treated for a selected period of time at temperatures between 760 °C to 860 °C in H₂ gas.
10. The device of item 1, wherein the growing the second semiconductor crystalline material is strained Ge and the first semiconductor crystalline material a SiGe alloy.
11. A method of manufacturing a semiconductor structure, comprising:
   providing a semiconductor crystalline substrate;
   forming an insulator defining openings to a surface of the substrate; and
   growing a first semiconductor crystalline material lattice-mismatched with the substrate within the openings of the insulator;
   polishing a top surface of the first semiconductor crystalline material and the insulator;
   growing a second semiconductor crystalline material over the polished first semiconductor crystalline material; and
   heating the polished top surface at a selected temperature range to reduce impurities at the interface of the first and second semiconductor crystalline material.
12. The method of item 11, wherein the heating comprises heating at temperatures between 760 °C to 860 °C.
13. The method of item 11, wherein the surface of the second semiconductor crystalline material has a surface roughness RMS of about 5nm or less, about 3nm or less, about 1 nm or less, about 0.5nm or less, or no greater than 0.3nm.
14. The method of item 11, wherein the interface has reduced oxygen impurity concentrations.
15. The method of item 11, wherein the second semiconductor crystalline material is elastically strained at least along a first direction relative to the opening, along a second direction perpendicular to the first direction or along both the first and second directions.
16. The method of item 11, wherein the openings have an aspect ratio sufficient to trap defects in the crystalline material, and further comprising forming a semiconductor device at least in part in an opening.
17. The method of item 11, wherein the heating comprises heating at a temperature range independent of a temperature used in the growing a second semiconductor crystalline material.
18. A method of manufacturing a semiconductor structure comprising:
   epitaxially growing by CVD a first semiconductor crystalline material on a polished surface of a lattice-mismatched semiconductor crystalline material exposed within an opening of an insulator; and
   cleaning the polished surface by heating to reduce an oxygen impurity concentration below a prescribed level.
19. The method of item 18, wherein the first crystalline material is a group IV element or compound including at least one group IV element.
20. The method of one of item 18, wherein the growing step includes growing strained Ge on a SiGe alloy.

## Claims

1. A semiconductor device, comprising:
a composite structure comprising a first semiconductor crystalline material interspersed with a high aspect ratio to a second material, the composite structure to have a planar surface; and
a strained second semiconductor crystalline material over the first semiconductor crystalline material at the planar surface, wherein the surface of the first semiconductor crystalline material has a surface roughness RMS of 5nm or less, and wherein an interface between the first and second semiconductor crystalline materials has reduced impurity concentrations.

2. The device of claim 1, wherein the surface of the second semiconductor crystalline material has a surface roughness RMS of about 4nm or less, about 3nm or less, about 1 nm or less, about 0.5nm or less, or no greater than 0.3nm.

3. The device of claim 1, wherein the interface has reduced oxygen impurity concentrations.

4. The device of claim 1, wherein the strain is along a longitudinal direction of the opening, perpendicular to the longitudinal direction or both along and perpendicular to the longitudinal.

5. The device of claim 1, wherein the composite structure comprises: a semiconductor crystalline substrate;
an insulator having an opening to the substrate;
the first semiconductor crystalline material within the opening in the insulator, the first semiconductor crystalline material being lattice-mismatched with the substrate.

6. The device of claim 1, wherein the crystalline material is a group III-V compound.

7. The device of claim 1, wherein the growing the second semiconductor crystalline material is strained Ge and the first semiconductor crystalline material a SiGe alloy.

8. A method of manufacturing a semiconductor structure, comprising:
providing a semiconductor crystalline substrate;
forming an insulator defining openings to a surface of the substrate; and
growing a first semiconductor crystalline material lattice-mismatched with the substrate within the openings of the insulator;
polishing a top surface of the first semiconductor crystalline material and the insulator;
growing a second semiconductor crystalline material over the polished first semiconductor crystalline material; and
heating the polished top surface at a selected temperature range to reduce impurities at the interface of the first and second semiconductor crystalline material.

9. The method of claim 8, wherein the heating comprises heating at temperatures between 760 °C to 860 °C.

10. The method of claim 8, wherein the surface of the second semiconductor crystalline material has a surface roughness RMS of about 5nm or less, about 3nm or less, about 1 nm or less, about 0.5nm or less, or no greater than 0.3nm.

11. The method of claim 8, wherein the interface has reduced oxygen impurity concentrations.

12. The method of claim 8, wherein the second semiconductor crystalline material is elastically strained at least along a first direction relative to the opening, along a second direction perpendicular to the first direction or along both the first and second directions.

13. The method of claim 8, wherein the heating comprises heating at a temperature range independent of a temperature used in the growing a second semiconductor crystalline material.

14. A method of manufacturing a semiconductor structure comprising:
epitaxially growing by CVD a first semiconductor crystalline material on a polished surface of a lattice-mismatched semiconductor crystalline material exposed within an opening of an insulator; and
cleaning the polished surface by heating to reduce an oxygen impurity concentration below a prescribed level.

15. The method of claim 14, wherein the first crystalline material is a group IV element or compound including at least one group IV element.
